# EUROPEAN PATENT APPLICATION

(11) **EP 1 956 433 A1**
(43) Date of publication of application: **13.08.2008**
(21) Application number: 08001782.5
(22) Date of filing: 31.01.2008
(51) Int. Cl.: G03F 7/20, G02F 1/1362, G02F 1/1339

(54) **Method for forming photoresist pattern, method for manufacturing display panel, and method for manufacturing display device**

(30) Priority: 06.02.2007 KR 20070012281
(71) Applicant: Samsung Electronics Co., Ltd., Suwon-si, Gyeonggi-do 442-742 (KR)
(72) Inventor: Shin, Kyoung-Ju, Hwaseong-si Gyeonggi-do (KR); Souk, Jun-Hyung, Yongin-si Gyeonggi-do (KR); Chai, Chong-Chul, Mapo-gu Seoul (KR)
(74) Representative: Schmidt, Sven Hendrik

(57) **Abstract**

A method for forming a photoresist pattern includes forming a photoresist, and forming a photoresist pattern having a step portion by performing a light exposure process a different number of times according to a region. A method for manufacturing a display panel and a method for manufacturing a display device are also provided.

## Description

This application claims priority to Korean Patent Application No. 2007-0012281, filed on February 6, 2007, and all the benefits accruing therefrom under 35 U.S.C. §119, the contents of which in its entirety are herein incorporated by reference.

### BACKGROUND OF THE INVENTION

### 1. Field of the Invention

The present invention relates to a method for forming a photoresist pattern with a step portion, a method for manufacturing a display panel and a method for manufacturing a display device, and more particularly, to a method for forming a photoresist pattern, a method for manufacturing a display panel and a method for manufacturing a display device in which manufacturing costs are reduced.

### 2. Description of the Related Art

A liquid crystal display ("LCD") panel includes a thin film transistor ("TFT") array substrate, a color filter array substrate, and a liquid crystal layer interposed between the TFT array substrate and the color filter array substrate.

The TFT array substrate includes a gate line arranged in a transverse direction, a data line arranged in a longitudinal direction to cross the gate line, a TFT formed at a crossing point of the gate and data lines to be electrically connected to the gate and data lines, and a pixel electrode formed in a pixel region to be electrically connected to the TFT

The color filter array substrate includes a black matrix for preventing light leakage, a color filter layer having red R, green G and blue B color filters formed over the pixel region, and a common electrode for forming an electric field together with the pixel electrode.

The LCD panel drives a liquid crystal layer by an electric field formed by a voltage difference between a data voltage supplied to the pixel electrode and a common voltage supplied to the common electrode to display an image.

In a process for manufacturing such an LCD panel, an exposure mask is usually used to form a desired pattern. Particularly, the TFT array substrate is manufactured by a four-mask process in which a gate insulating layer, a semiconductor layer, an ohmic contact layer, and a data pattern are formed. At this time, a slit mask with slits or a half-tone mask is used in order to form a channel of the TFT.

### BRIEF SUMMARY OF THE INVENTION

Aspects of the present invention provide a method for forming a photoresist pattern, a method for manufacturing a display panel, and a method for manufacturing a display device in which a display panel is manufactured without using a mask, thereby reducing a manufacturing cost, by exposing a photoresist to light according to a region by using a digital exposure unit.

Exemplary embodiments of the present invention provide a method for forming a photoresist pattern, the method including forming a photoresist, and forming a photoresist pattern having a step portion by performing a light exposure process a different number of times according to a region.

The photoresist pattern may include a first region and a second region lower than the first region, wherein a number of light exposure times for the first region is more than a number of light exposure times for the second region.

The method for forming a photoresist pattern may further include subjecting first and second regions of the photoresist, corresponding to the first and second regions of the photoresist pattern, to a first light exposure, and subjecting the first region of the photoresist to a second light exposure.

During the first light exposure, light of different intensity may be irradiated to the first and second regions of the photoresist, respectively.

During the first light exposure, light of stronger intensity may be irradiated to the first region of the photoresist than to the second region of the photoresist.

The method for forming a photoresist pattern may further include, during the first light exposure, irradiating light of a same intensity to the first and second regions of the photoresist, and during the second light exposure, irradiating light of different intensity compared to the first light exposure.

The photoresist pattern may include a first region and a second region lower than the first region, wherein a number of light exposure times for the first region is less than a number of light exposure times for the second region.

Other exemplary embodiments of the present invention provide a method for manufacturing a display panel, the method including forming a gate pattern having a gate line and a gate electrode on a substrate through a first conductive layer, sequentially forming a gate insulating layer, an amorphous silicon layer, a doped amorphous silicon layer, a second conductive layer, and a photoresist over the substrate, wherein the photoresist includes a channel region through which a channel of a thin film transistor ("TFT") is to be formed and a data pattern region through which a data pattern having source and drain electrodes of the TFT and a data line is to be formed, subjecting the photoresist to a light exposure to form a photoresist pattern having a step portion, wherein the channel region and the data pattern region receive a different number of light exposure times, performing an etching process using the photoresist pattern to form the TFT and the data line, forming a passivation film over the substrate, the passivation film having a pixel contact hole which exposes a portion of a drain electrode, and forming a pixel electrode on the passivation film, the pixel electrode electrically connected to the drain electrode via the pixel contact hole.

The photoresist may have negative photosensitivity.

The photoresist pattern may have a step portion including a data pattern region through which the source and drain electrodes and the data line are to be formed and a channel region through which the channel of the TFT is to be formed, and the data pattern region of the photoresist pattern may be higher than the channel region of the photoresist pattern.

The number of light exposure times for the channel region may be less than the number of light exposure times for the data pattern region.

The method for forming a display panel may further include subjecting the photoresist of the channel region and the data pattern region to a first light exposure, and subjecting the photoresist of the data pattern region to a second light exposure.

During the first light exposure, light of different intensity may be irradiated to the channel region of the photoresist and the data pattern region of the photoresist, respectively.

During the first light exposure, light of stronger intensity may be irradiated to the data pattern region of the photoresist than to the channel region of the photoresist.

The method for forming a display panel may further include, during the first light exposure, irradiating light of a same intensity to the channel region of the photoresist and the data pattern region of the photoresist, and during the second light exposure, irradiating light of different intensity compared to the first light exposure.

The method for forming a display panel may further include, after the second light exposure, subjecting the data pattern region to at least one more light exposure.

The photoresist may have a positive photosensitivity.

The photoresist pattern may have a step portion including a data pattern region through which the source and drain electrodes and the data line are to be formed and a channel region through which the channel of the TFT is to be formed, and the data pattern region of the photoresist pattern may be higher than the channel region of the photoresist pattern.

Still other exemplary embodiments of the present invention provide a method for manufacturing a display device, the method including preparing a TFT array substrate, preparing for a color filter array substrate, opposite to the TFT array substrate, forming a photoresist on any of the TFT array substrate and the color filter array substrate, and subjecting the photoresist to a light exposure at least twice to form a column spacer and an alignment layer which has a protruding portion and an inclined portion for alignment of liquid crystal molecules.

The photoresist may have negative photosensitivity.

The method for manufacturing a display device may further include, subjecting a surface of the photoresist to a first light exposure, subjecting a portion of the photoresist through which the column spacer is to be formed and the protruding portion to a second light exposure, and subjecting the portion of the photoresist through which the column spacer is to be formed to a third light exposure.

Light of stronger intensity may be supplied for the third light exposure compared to the second light exposure.

The method for manufacturing a display device may further include, after the third light exposure, subjecting the portion of the photoresist through which the column spacer is to be formed to a light exposure.

The photoresist may have positive photosensitivity.

### BRIEF DESCRIPTION OF THE DRAWINGS

The above and other features of the present invention will be described in reference to certain exemplary embodiments thereof with reference to the attached drawings in which:
FIG. 1 is a plan view illustrating an exemplary LCD panel manufactured according to an exemplary embodiment of the present invention;
FIG. 2 is a cross-sectional view taken along line I-I' of FIG. 1;
FIG. 3 is a perspective view illustrating an exemplary digital exposure unit used for manufacturing the exemplary LCD panel according to the exemplary embodiment of the present invention;
FIG. 4 is a block diagram illustrating an exemplary exposure head of the exemplary digital exposure unit of FIG. 3;
FIGs. 5A to 5E show a first exemplary process for manufacturing an exemplary TFT array substrate according to an exemplary embodiment of the present invention;
FIGs. 6A to 6H show a second exemplary process for manufacturing the exemplary TFT array substrate according to an exemplary embodiment of the present invention;
FiGs. 7A and 7B show a third exemplary process for manufacturing the exemplary TFT array substrate according to an exemplary embodiment of the present invention;
FIGs. 8A and 8B show a fourth exemplary process for manufacturing the exemplary TFT array substrate according to an exemplary embodiment of the present invention; and
FiGs. 9A to 9F are cross-sectional views illustrating a column spacer and an alignment layer on an exemplary color filter array substrate according to an exemplary embodiment of the present invention.

### DETAILED DESCRIPTION OF THE INVENTION

The invention will now be described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments of the present invention are described herein with reference to cross section illustrations that are schematic illustrations of idealized embodiments of the present invention. As such, variations from the shapes of the illustrations as a result, for example, of manufacturing techniques and/or tolerances, are to be expected. Thus, embodiments of the present invention should not be construed as limited to the particular shapes of regions illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present invention.

In a conventional method of manufacturing a thin film transistor ("TFT") array substrate, the slit mask and the half-tone mask for forming a channel of the TFT are high in price, thereby increasing manufacturing costs of the LCD panel. In addition, the slit mask and the half-tone mask have a problem in that a channel region of the TFT is nonuniformly formed due to an exposure dose difference in case of an LCD panel manufactured by using a slit mask or a half-tone mask for the first time and an LCD panel manufactured by using a slit mask or a half-tone mask used many times.

The present invention provides a method for manufacturing a display panel without using a mask, thereby reducing a manufacturing cost.

Hereinafter, the present invention will be described in detail with reference to the accompanying drawings.

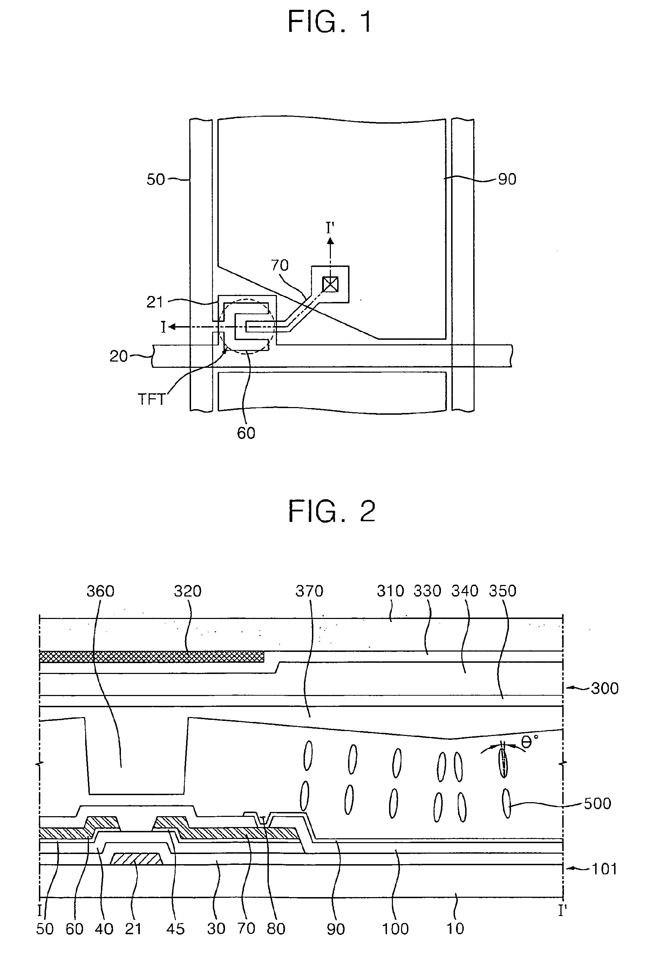

FIG. 1 is a plan view illustrating an exemplary LCD panel manufactured according to an exemplary embodiment of the present invention. FIG. 2 is a cross-sectional view taken along line I-I' of FIG. 1.

Referring to FIGs. 1 and 2, the LCD panel manufactured according to an exemplary embodiment of the present invention includes a TFT array substrate 101, a color filter array substrate 300, and liquid crystal molecules 500 interposed between the TFT array substrate 101 and the color filter array substrate 300.

The TFT array substrate 101 includes a gate line 20 arranged in a transverse direction, a first direction, a data line 50 arranged in a longitudinal direction, a second direction, to cross the gate line 20, a TFT formed adjacent a crossing point of the gate and data lines 20 and 50 to be electrically connected to the gate and data lines 20 and 50, and a pixel electrode 90 formed in a pixel region to be electrically connected to the TFT, which are formed on a lower substrate 10.

The gate line 20 is formed on the lower substrate 10 and supplies gate on and off voltages applied from a gate driving portion (not shown) to a gate electrode 21 of the TFT.

The data line 50 is formed to cross the gate line 20, and a portion of a gate insulating layer 30 is interposed between the gate and data lines 20 and 50. The data line 50 may be substantially perpendicular to the gate line 20. The data line 50 supplies a data voltage applied from a data driving portion (not shown) to a source electrode 60 of the TFT.

The TFT includes the gate electrode 21 extending from the gate line 20, the gate insulating layer 30 formed to cover the gate electrode 21, a semiconductor layer 40 formed on a portion of the gate insulating layer 30 overlapping the gate electrode 21, the source electrode 60 formed over the semiconductor layer 40 and partially overlapping the gate electrode 21 to be electrically connected to the data line 50, a drain electrode 70 formed over the semiconductor layer 40 and partially overlapping the gate electrode 21 to face the source electrode 60, and an ohmic contact layer 45 formed between the semiconductor layer 40 and the source and drain electrodes 60 and 70.

A passivation film 100 is formed over the surface, such as over the entire surface or substantially the entire surface, of the lower substrate 10 to cover the TFT The passivation film 100 has a pixel contact hole 80 formed therein. The pixel electrode 90 is formed on the passivation film 100 to be electrically connected to the drain electrode 70 via the pixel contact hole 80.

An alignment layer (not shown) may be further formed on the pixel electrode 90. The alignment layer determines an alignment angle of the liquid crystal molecules 500.

In the TFT array substrate 101, the TFT is turned on by a gate on voltage supplied through the gate line 20, so that a data voltage is applied to the pixel electrode 90 through the data line 50 to thereby drive the liquid crystal molecules 500 within a liquid crystal layer.

The color filter array substrate 300 includes a black matrix 320, a color filter layer 330, a common electrode 350, a column spacer 360, and an alignment layer 370.

The black matrix 320 is formed on an upper substrate 310 in a matrix form to define a region corresponding to the pixel region where color filters are to be formed. The black matrix 320 is formed to overlap the gate line 20, the data line 50 and the TFT of the TFT array substrate 101 when the color filter array substrate 300 and the TFT array substrate 101 are assembled together. The black matrix 320 shields light which is transmitted due to an undesired arrangement of liquid crystal molecules 500, thereby improving a contrast ratio of an LCD device. The black matrix 320 also shields light from being directly incident to the TFT, thereby preventing a light leakage current of the TFT. To this end, the black matrix 320 may be made of an opaque metal or opaque polymer resin.

The color filter layer 330 includes red R, green G and blue B color filters for realizing various colors. The red R, green G and blue B color filters realize red, green and blue colors by absorbing and transmitting light of a certain wavelength through red, green and blue pigments contained therein, respectively. At this time, various colors can be realized by an additive color mixture of the red R, green G and blue B light which pass through the red R, green G and blue B color filters. The red R, green G and blue B color filters may be arranged in a row, i.e., in a stripe form, although other arrangements are within the scope of these embodiments.

The common electrode 350 applies a common voltage to the liquid crystal molecules 500 in the liquid crystal layer when a data voltage is applied to the pixel electrode 90. The common electrode 350 is made of a transparent conductive material such as indium tin oxide ("ITO") or indium zinc oxide ("IZO").

An overcoat layer 340 may be further formed to planarize the color filter layer 330 as shown in FIG. 2. The overcoat layer 340 removes a step difference occurring in a region where the color filter layer 330 and the black matrix 320 overlap, thereby preventing an abnormal driving of the liquid crystal layer caused by distortion of an electric field.

The column spacer 360 is formed on either the upper substrate 310 or the lower substrate 10. If the column spacer 360 is formed on the upper substrate 310, it is formed to overlap the black matrix 320, whereas if the column spacer 360 is formed on the lower substrate 10, it is formed to overlap the opaque metal line, e.g., the gate and data lines 20 and 50 and the TFT. In an exemplary embodiment of the present invention, the column spacer 360 is formed on the upper substrate 310 to overlap the TFT as shown in FIG. 2.

The column spacer 360 may have various forms such as, but not limited to, a circular truncated cone or a truncated pyramid.

The alignment layer 370 is formed for the alignment of the liquid crystal molecules 500 and is preferably made of the same material as the column spacer 360. The alignment layer 370 has a predetermined pretilt angle θ° to improve a response speed of the liquid crystal molecules 500 aligned vertically in a vertical alignment ("VA") mode LCD device. The alignment layer 370, as shown in FIG. 2, is formed substantially in a mountain shape, so that the liquid crystal molecules 500 are aligned vertically to an inclined surface, and so the liquid crystal molecules 500 are aligned at a pretilt angle θ°. In other words, the alignment layer 370 may have a triangular cross-sectional shape with an apex of the triangular cross-sectional shape pointing towards a selected area of the TFT array substrate 101, such as a central region of each pixel region.

The column spacer 360 and the alignment layer 370 are preferably made of a photosensitive material such as a photoresist.

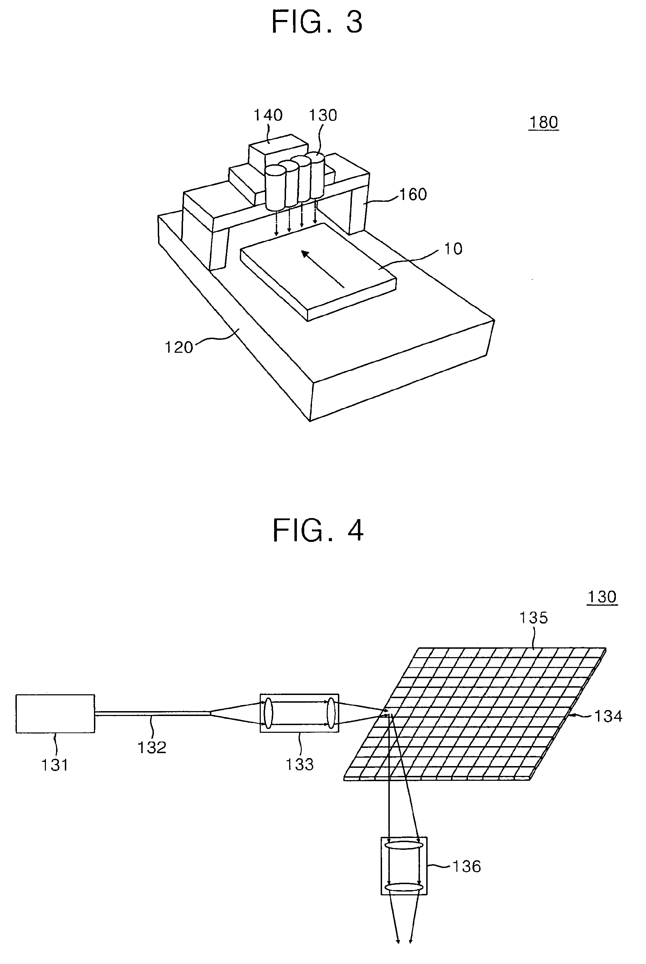

In order to manufacture the above-described LCD panel, in the exemplary embodiment of the present invention, a digital exposure unit 180 is employed, as will be further described below with respect to FIG. 3. That is, the TFT array substrate 101 and the color filter array substrate 300 are manufactured by using a digital exposure unit, such as digital exposure unit 180, instead of a mask, thereby reducing a manufacturing cost of the LCD panel.

FIG. 3 is a perspective view illustrating an exemplary digital exposure unit used for manufacturing the exemplary LCD panel according to an exemplary embodiment of the present invention. FIG. 4 is a block diagram illustrating an exemplary exposure head of the exemplary digital exposure unit of FIG. 3.

Referring to FIGs. 3 and 4, the digital exposure unit 180 includes a stage 120 for transporting, by way of example, the lower substrate 10, an exposure head 130 for irradiating a laser beam to the lower substrate 10, a first support 140 for supporting the exposure head 130, and a second support 160 for maintaining a gap between the lower substrate 10 and the exposure head 130.

The stage 120 transports the lower substrate 10 so that the lower substrate 10, on which a pattern is to be formed, can be passed below the exposure head 130. At this time, the stage 120 transports the lower substrate 10 at an appropriate speed so that a photoresist formed on the lower substrate 10 can be photosensitized by a laser beam irradiated from the exposure head 130.

The first support 140 holds the exposure head 130. Also, a connection device for supplying pattern data to the exposure head 130 from an external portion may be arranged as the first support 140. That is, the first support 140 may include a connection device for supplying pattern data to the exposure head 130 in addition to holding the exposure head 130.

The second support 160 provides a place on which the first support 140 is located and provides a space through which the lower substrate 10 can be passed below the exposure unit 130. The second support 160 may provide a bridge over the stage 120 on which the first support 140 is seated for holding the exposure unit 130 over the stage 120.

In FIG. 3, it has been described that the light exposure unit 180 is used to have a pattern formed on the lower substrate 10 subjected to a light exposure, but it can also be used to have patterns such as the column spacer 360 and the alignment layer 370 formed on the upper substrate 310 subjected to a light exposure.

The exposure head 130 irradiates a laser beam to the lower substrate 10 according to the pattern data. To this end, a plurality of exposure heads 130 are provided within the digital exposure unit 180, and each exposure head 130 includes a digital micromirror device ("DMD") 134. The DMD 134 includes a plurality of micromirrors 135 arranged in a lattice form. The DMD 134 has a controller which includes a data processing portion and a mirror driving control portion. The data processing portion generates a control signal for driving each micromirror 135 within a region to be controlled in the DMD 134 according to the inputted pattern data. The mirror driving control portion controls an angle of a reflecting surface of each micromirror 135 of the DMD 134 based on the control signal generated from the image data processing portion. The digital exposure unit 180 further includes at least one laser 131 for generating a laser beam and at least one optical fiber 132 for transmitting a laser beam generated from the laser 131 to the DMD 134. The laser 131 may be arranged outside the exposure head 130. In this instance, the optical fiber 132 transmits the laser beam generated from the laser 131 to the exposure head 130.

A first lens system 133 is arranged on a light incident side of the DMD 134. The first lens system 133 condenses a laser beam supplied from the laser 131 through the optical fiber 132 and supplies the DMD 134 with the laser beam. The first lens system 133 converts the laser beam outputted from the optical fiber 132 into a parallel laser beam. To this end, the first lens system 133 includes a lens for correcting the parallel laser beam to be uniformly distributed and a condensing lens for condensing the uniformly distributed laser beam to the DMD 134.

Each micromirror 135 in the DMD 134 can be inclined at an angle of ±10°. A highly reflective material such as aluminum Al is deposited on a surface of the micromirror 135. Preferably, the micromirror 135 has reflectivity of at least 90%. The laser beam incident to the DMD 134 is reflected in an inclined direction of the micromirror 135 by controlling a gradient of the micromirror 135 of the DMD 134 according to the pattern data.

On a light reflecting side of the DMD 134, a second lens system 136 for imaging the reflected laser beam onto the substrate, such as lower substrate 10, is arranged. The second lens system 136 is arranged between the DMD 134 and the substrate to condense the laser beam reflected by the DMD 134 and supply it to the substrate.

As described above, the digital exposure unit 180 photosensitizes a photoresist formed on the substrate which passes below the exposure head 130 without using a discrete mask.

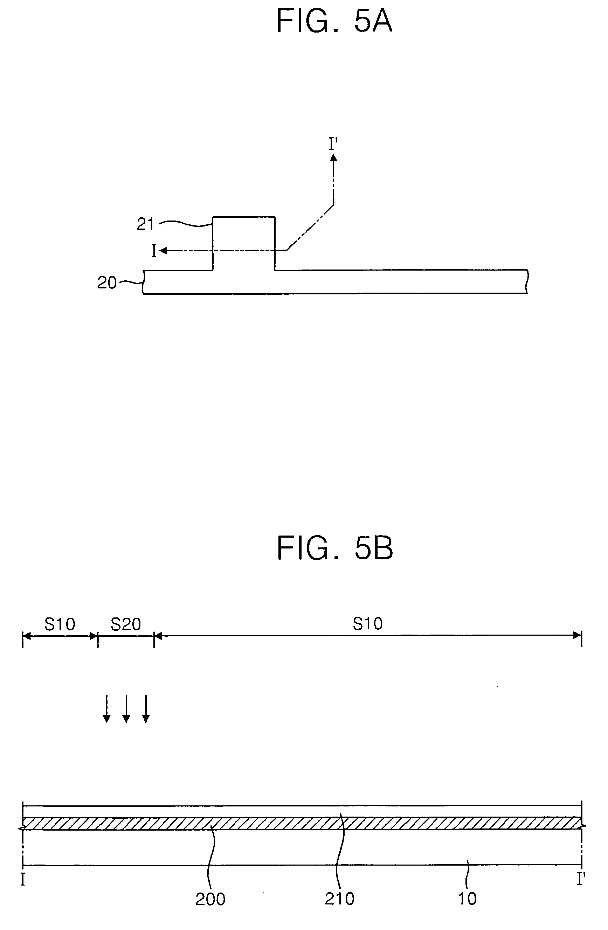

An exemplary method for manufacturing the exemplary LCD panel using the exemplary digital exposure unit is described below with reference to FIGs. 5A to 9F.

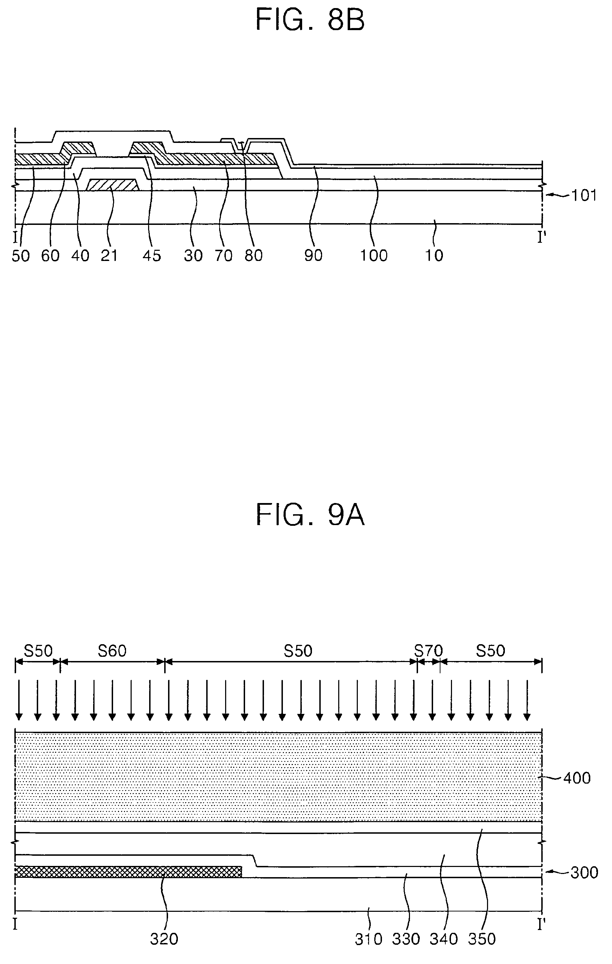

FiGs. 5A to 8B show an exemplary process for manufacturing the exemplary TFT array substrate according to an exemplary embodiment of the present invention, and FIGs. 9A to 9F show an exemplary process for forming the column spacer and the alignment layer on the exemplary color filter array substrate according to an exemplary embodiment of the present invention.

FIG. 5A is a plan view illustrating an exemplary first process for manufacturing the exemplary TFT array substrate according to an exemplary embodiment of the present invention, and FiGs. 5B to 5E are cross-sectional views sequentially illustrating the exemplary first process for manufacturing the exemplary TFT array substrate according to the exemplary embodiment of the present invention, taken along line I-I' of FIG. 5A. A gate pattern is formed through the exemplary first manufacturing process.

Referring to FIGs. 5A to 5E, a gate pattern having a gate line 20 and a gate electrode 21 extending from the gate line 20 are formed on a lower substrate 10. The lower substrate 10 is made of transparent glass or plastic.

In more detail, as shown in FIG. 5B, a first conductive layer 200 is formed on the lower substrate 10 by using a deposition technique such as a sputtering technique. The first conductive layer 200 is made of a metal material such as molybdenum (Mo), titanium (Ti), copper (Cu), aluminum nitride (AlNd), aluminum (AI), chromium (Cr), a Mo alloy, a Cu alloy, and an Al alloy. The first conductive layer 200 may have a single layer structure or a multi-layer structure.

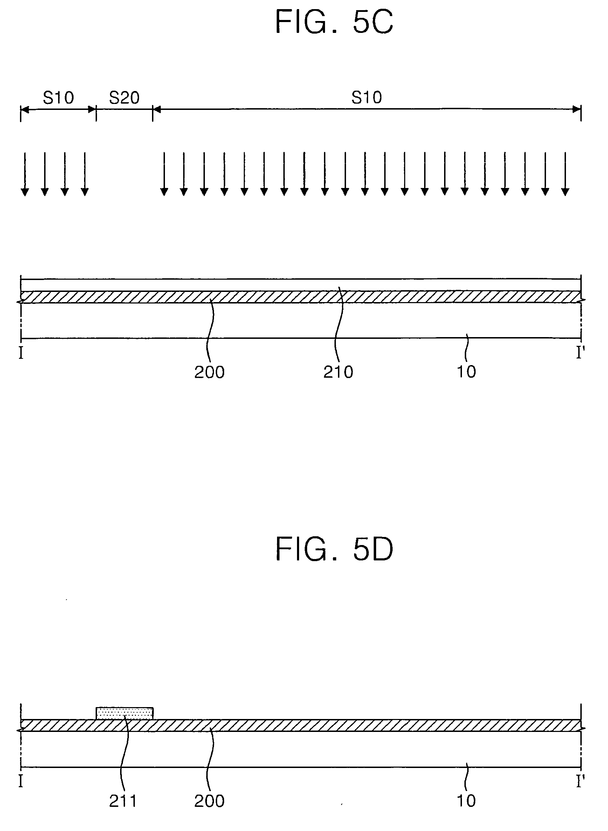

Then, a first photoresist 210 is formed on the first conductive layer 200. In this exemplary embodiment, as shown in FIG. 5B, the first photoresist 210 is made of a material with negative photosensitivity. The first photoresist 210 is then subject to a light exposure. Here, the first photoresist 210 includes a gate pattern region S20 through which a first photoresist pattern 211, shown in FIG. 5D, is to be formed by a laser beam irradiated from the digital exposure unit 180 and a non-pattern region S10 in which the first photoresist 210 is removed.

Alternatively, the first photoresist 210 may be made of a material with positive photosensitivity. In case of a material with positive photosensitivity, a portion exposed to light is removed by a development process.

Referring to FIG. 5C, a laser beam is irradiated from the digital exposure unit 180 to the non-pattern region S10 of the first photoresist 210 made of a material with positive photosensitivity. The non-pattern region S10 of the first photoresist 210 exposed to the laser beam is removed by the development process, and the gate pattern region S20 which is not exposed to the laser beam remains.

At this time, the light exposure process may be repetitively performed by using the digital exposure unit 180. That is, in order to form the first photoresist pattern 211 at the relatively thick thickness or in order to perfectly remove the non-pattern region S10 of the first photoresist 210, the light exposure can be repetitively performed.

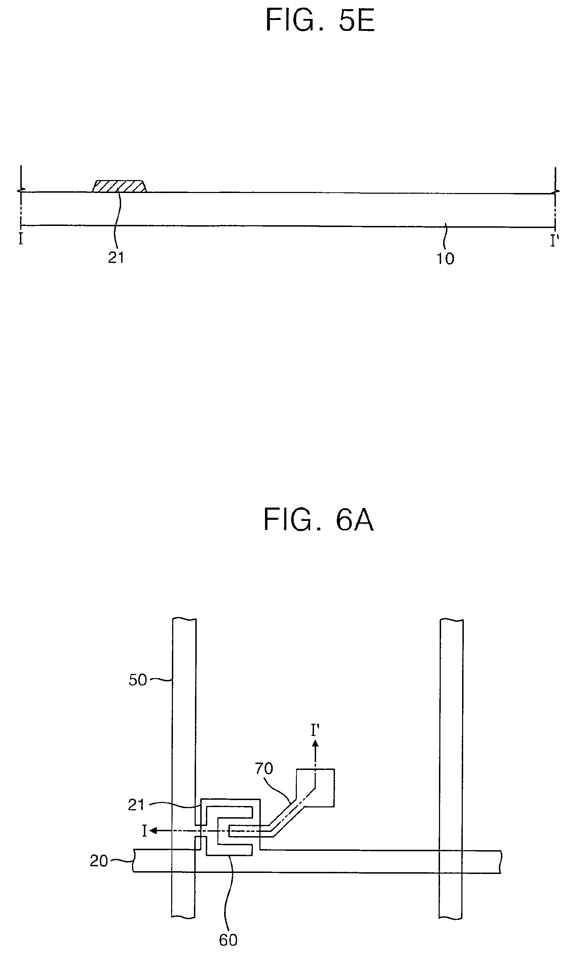

Next, after the gate pattern region S20 is cured by the laser beam irradiated from the digital exposure unit 180 and developed, a first photoresist pattern 211 is formed as shown in FIG. 5D. Thereafter, the lower substrate 10 is subjected to an etching process to etch a portion of the first conductive layer 200 corresponding to the non-pattern region S10 which is not covered with the first photoresist pattern 211. Then, the first photoresist pattern 211 is removed, whereby the gate pattern having the gate line 20 and the gate electrode 21 is formed as shown in FIG. 5E.

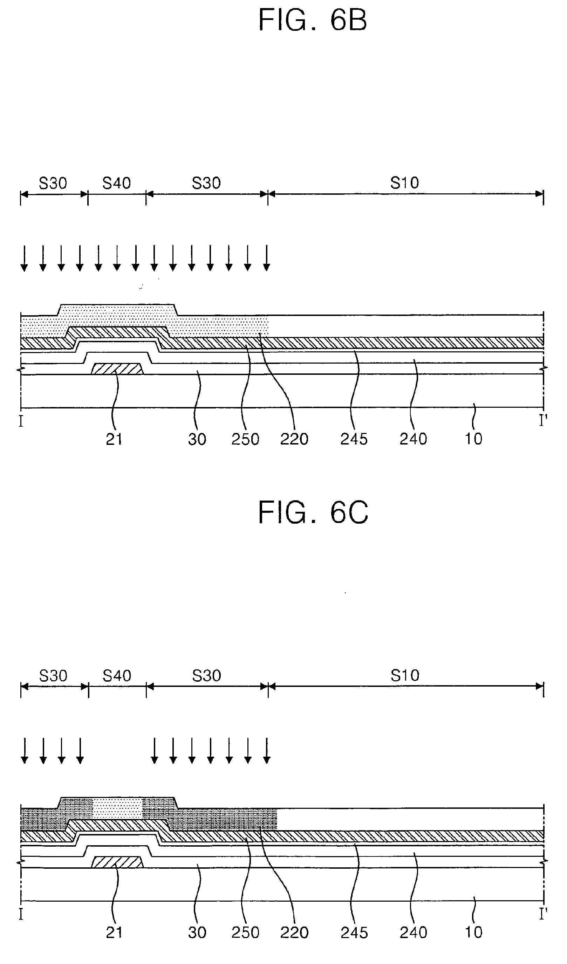

FIG. 6A is a plan view illustrating an exemplary second process for manufacturing the exemplary TFT array substrate according to the exemplary embodiment of the present invention, and FiGs. 6B to 6H are cross-sectional views sequentially illustrating the exemplary second process for manufacturing the exemplary TFT array substrate according to the exemplary embodiment of the present invention, taken along line I-I' of FIG. 6A. A semiconductor layer and a data pattern are formed through the exemplary second manufacturing process.

Referring to FIGs. 6A to 6H, a gate insulating layer 30 is formed over the whole surface of the lower substrate 10 to cover the gate pattern, and a semiconductor layer 40 for forming a channel of the TFT and a data pattern having source and drain electrodes 60 and 70 and a data line 50 electrically connected to the source electrode 60 are formed. An ohmic contact layer 45 is formed between the semiconductor layer 40 and the source and drain electrodes 60 and 70. The semiconductor layer 40 is formed on a portion of the gate insulating layer 30 overlapping the gate electrode 21, and the source and drain electrodes 60 and 70 are formed on the semiconductor layer 40, opposite to each other.

More specifically, referring to FIG. 6B, the gate insulating layer 30, an amorphous silicon ("a-Si") layer 240, a doped a-Si layer 245 and a second conductive layer 250 are sequentially deposited over the lower substrate 10 having the gate pattern. In an exemplary embodiment, the gate insulating layer 30, the a-Si layer 240 and the doped a-Si layer 245 are formed by using plasma enhanced chemical vapor deposition ("PECVD") technique, and the second conductive layer 250 is formed by using a sputtering technique.

The gate insulating layer 30 is made of an insulating material such as silicon oxide (SiOx) or silicon nitride (SiNx), and the second conductive layer 250 is made of a metal material such as Mo, Ti, Cu, AINd, Al, Cr, a Mo alloy, a Cu alloy, and an Al alloy. The second conductive layer 250 may have a single layer structure or a multi-layer structure.

Next, a second photoresist 220 is formed on the second conductive layer 250. The second photoresist 220 is preferably made of the same material as the first photoresist 210. In FIG. 6B, an exemplary embodiment of the second photoresist 220 includes a material with negative photosensitivity. The second photoresist 220 may be formed to have a thicker thickness than the first photoresist 210.

Thereafter, the second photoresist 220 is subjected to a first light exposure using the digital exposure unit 180. The second photoresist 220 includes a non-pattern region S10 to which the laser beam is not irradiated, a data pattern region S30 through which the source and drain electrodes 60 and 70 of the TFT and the data line 50 are to be formed and a channel region S40 through which a channel of the TFT is to be formed. As shown in FIG. 6B, during the first light exposure, the same amount of the laser beam is irradiated to the data pattern region S30 and the channel region S40.

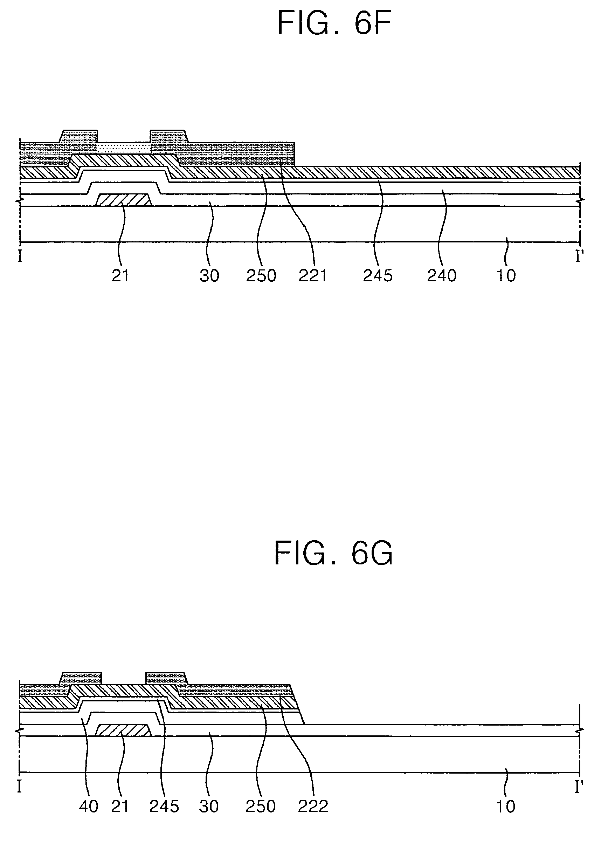

Subsequently, as shown in FIG. 6C, the second photoresist 220 is subjected to a second light exposure using the digital exposure unit 180. That is, the laser beam is irradiated only to the data pattern region S30 during the second light exposure. At this time, the first and second light exposure processes are performed by passing the lower substrate 10 below the exposure head of the digital exposure unit 180 twice. During the light exposure process, the amount of the laser beam irradiated to the data pattern region S30 can be adjusted through the micromirrors 135 contained in the exposure head 130 of the digital exposure unit 180. For example, if the amount of the laser beam irradiated to the data pattern region S30 during the second light exposure is equal to the amount of the laser beam irradiated during the first light exposure, the second photoresist 220 is not perfectly cured, so that the second photoresist 220 is only partially removed during the later development process. It is because when a third photoresist pattern 222 is formed, as shown in FIG. 6G, the thickness of the third photoresist pattern 222 is very thin, so that the data pattern may be partially etched. In order to prevent this phenomenon, a greater amount of the laser beam is irradiated during the second light exposure compared to the first light exposure, so that the whole photoresist 220 can remain during the development process. To this end, an angle of each micromirror 135 contained in the pattern data is adjusted to irradiate the laser beam reflected by each micromirror 135 concentrically to the data pattern region S30.

In an exemplary embodiment, the intensity of the laser beam supplied from the laser 131 during the second light exposure can be increased. Therefore, the exposure dose for the data pattern region S30 can be increased without adjusting the micromirror 135.

Alternatively, the exposure dose for the data pattern region S30 can be increased such that the amount of the laser beam irradiated to the data pattern region S30 is increased by increasing the intensity of the laser beam and adjusting an angle of the micromirror 135.

In order to increase the exposure dose of the data pattern region S30, a light exposure process for subjecting only the data pattern region S30 to the light exposure can be further performed. That is, in a case where the intensity of the laser beam supplied from the laser 131 is constant and an angle of the micromirror 135 remains the same, a light exposure can be additionally or repetitively performed in the same way as the second light exposure so that the second photoresist 220 of the data pattern region S30 can not be removed during the development process.

In an alternative exemplary embodiment, the second photoresist 220 may be made of a photoresist with positive photosensitivity.

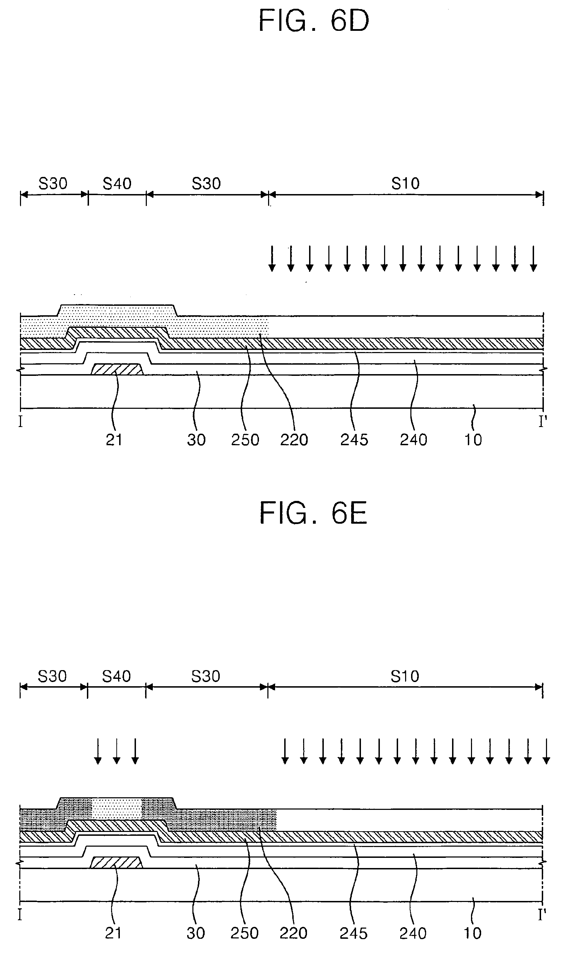

FIGs. 6D and 6E are cross-sectional views sequentially illustrating an exemplary light exposure process applied when the second photoresist 220 is made of a photoresist with positive photosensitivity.

As shown in FIG. 6D, the lower substrate 10 having the second photoresist 220 with positive photosensitivity formed thereon is subjected to a first light exposure using the digital exposure unit 180. That is, the digital exposure unit 180 irradiates the laser beam to the non-pattern region S10 during the first light exposure.

Next, as shown in FIG. 6E, the lower substrate 10 having the second photoresist 220 is subjected to a second light exposure using the digital exposure unit 180. That is, the digital exposure unit 180 irradiates the laser beam to the non-pattern region S10 and the channel region S40 during the second light exposure. At this time, the laser beam is not irradiated to the data pattern region S30. In exemplary embodiments, the non-pattern region S10 of the second photoresist 220 can be twice or more subjected to the first light exposure process or the laser beam with stronger intensity than the second exposure process can be irradiated to the non-pattern region S10 during the second exposure process. That is, since the non-pattern region S10 should be all removed in the later development process, the light exposure process can be additionally performed or the intensity of the laser beam can be increased to wholly photosensitize the second photoresist 220 of the non-pattern region S10.

Subsequently, the second photoresist 220 which has undergone the second light exposure is subjected to a development process, thereby forming a second photoresist pattern 221 as shown in FIG. 6F. In the data pattern region S30 through which the source and drain electrodes 60 and 70 and the data line 50 are to be formed, the second photoresist 220 still remains. In the channel region S40, a portion of the second photoresist 220 is removed, so that the second photoresist pattern 220 remaining on the channel region S40 has a thinner thickness than the second photoresist pattern 220 on the data pattern region S30. In the non-pattern region S10, the second photoresist 220 is completely removed.

As shown in FIG. 6G, the lower substrate 10 having the second photoresist pattern 221 is subjected to a first etching process, whereby an exposed portion of the second conductive layer 250, such as a portion of the second conductive layer 250 lying in the non-pattern region S10, is etched. Thereafter, a second etching process is performed to etch portions of the a-Si layer 240 and the doped a-Si layer 245 which are not covered with the second photoresist pattern 221, thereby forming the semiconductor layer 40. An ashing process using oxygen plasma is performed to remove the photoresist pattern of the channel region S40 corresponding to the channel of the second photoresist pattern 221 and to partially remove the second photoresist pattern 221 of the data pattern region S30, thereby forming a third photoresist pattern 222 as shown in FIG. 6G.

A third etching process using the third photoresist pattern 222 is performed to etch a portion of the second conductive layer 250 exposed by the third photoresist pattern 222 within the channel region S40, thereby separating the source electrode 60 and the drain electrode 70. A fourth etching process is performed to etch an exposed portion of the doped a-Si layer 245 between the semiconductor layer 40 and the source and drain electrodes 60 and 70, thereby forming the ohmic contact layer 45 while exposing a portion of the semiconductor layer 40 within the channel region S40.

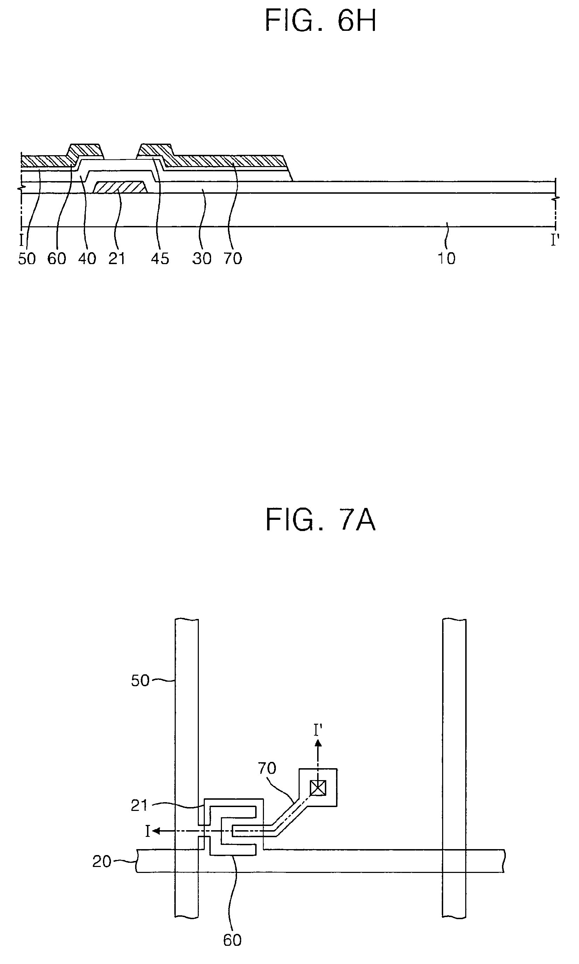

The third photoresist pattern 222 is removed by an ashing process, thereby completing the TFT as shown in FIG. 6H.

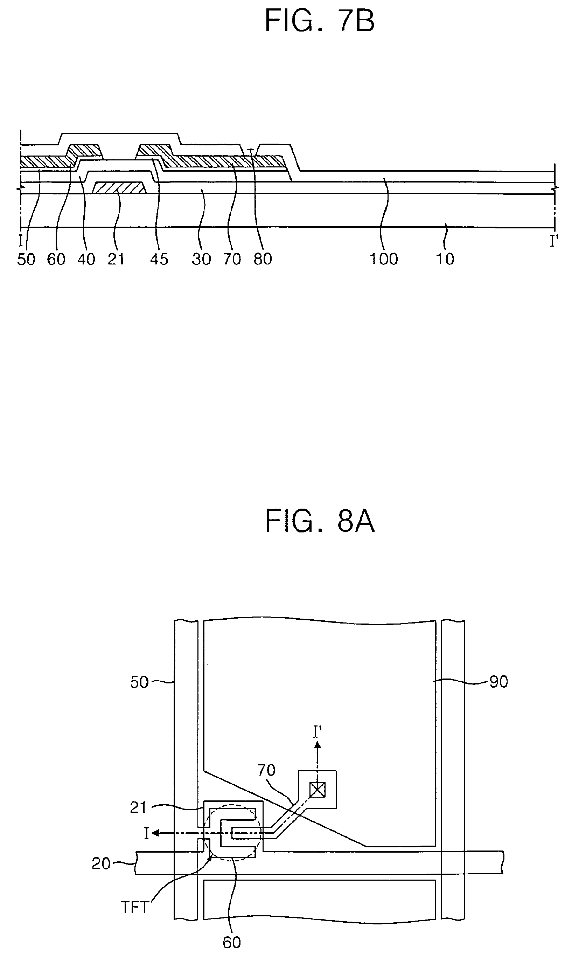

FIG. 7A is a plan view illustrating an exemplary third process for manufacturing the exemplary TFT array substrate according to an exemplary embodiment of the present invention, and FIG. 7B is a cross-sectional view taken along line I-I' of FIG. 7A.

Referring to FiGs. 7A and 7B, a passivation film 100 having a pixel contact hole 80 is formed by the third manufacturing process.

In more detail, the passivation film 100 is formed over the whole surface of the lower substrate 10 having the data pattern by using a PECVD technique, a spin coating technique, or a spinless coating technique, as shown in FIG. 7B.

In an exemplary embodiment, the passivation film 100 is formed of an inorganic insulating material by using a CVD or PECVD technique like the gate insulating layer 30. The passivation film 100 may be formed of an organic insulating material such as an acrylic-based organic compound, benzocyclobutene ("BCB") or perfluorocyclobutyl ("PFCB") by using a spin coating technique or a spinless coating technique. The passivation film 100 may have a dual-layer structure in which an inorganic insulating material layer and an organic insulating material layer are stacked.

A photoresist is coated on the passivation film 100 and is then subjected to a light exposure process and a development process to form a photoresist pattern on the passivation film 100. An etching process using the photoresist pattern is formed to form the pixel contact hole 80 which penetrates the passivation film 100 to expose a portion of the drain electrode 70 of the TFT.

FIG. 8A is a plan view illustrating an exemplary fourth process for manufacturing the exemplary TFT array substrate according to an exemplary embodiment of the present invention, and FIG. 8B is a cross-sectional view taken along line I-I' of FIG. 8A.

Referring to FiGs. 8A and 8B, a pixel electrode 90 is formed through the exemplary fourth manufacturing process.

More specifically, a third conductive layer (not shown) is deposited on the passivation film 100 by using a deposition technique such as a sputtering technique. The third conductive layer may be made of a transparent conductive material, and may be made of indium tin oxide ("ITO"), tin oxide ("TO"), or indium zinc oxide ("IZO"). Then, a photoresist is coated on the third conductive layer and is then subjected to a light exposure process using the digital exposure unit 180. A development process is performed to form a photoresist pattern. The third conductive layer is etched by an etching process using the photoresist pattern to thereby form the pixel electrode 90. The pixel electrode 90 is electrically connected to the drain electrode 70 via the pixel contact hole 80 as shown in FIG. 8B, thus substantially completing the TFT array substrate 101.

FIGs. 9A to 9F are cross-sectional views illustrating a column spacer and an alignment layer on an exemplary color filter array substrate according to an exemplary embodiment of the present invention.

Referring to FIGs. 9A to 9F, a third photoresist 400 is formed on a color filter array substrate 300 in which a black matrix 320, a color filter layer 330, an overcoat layer 340, and a common electrode 350 are formed on an upper substrate 310. The third photoresist 400 is formed on the common electrode 350.

The third photoresist 400 is formed at a thickness sufficient enough to maintain a cell gap between the TFT array substrate 101 and the color filter array substrate 300. That is, since the third photoresist 400 is patterned into a column spacer 360 having a predetermined height by a light exposure process and a development process, the third photoresist 400 should be formed at a height higher than or equal to the height of the column spacer 360. In an exemplary embodiment, the third photoresist 400 is made of a photoresist with negative photosensitivity.

Then, as shown in FIG. 9A, the third photoresist 400 is subjected to a first light exposure process using the digital exposure unit 180. In the first light exposure process, the column spacer region S60 and the protruding region S70 may be subjected to the first light exposure process as well as the inclined regions S50.

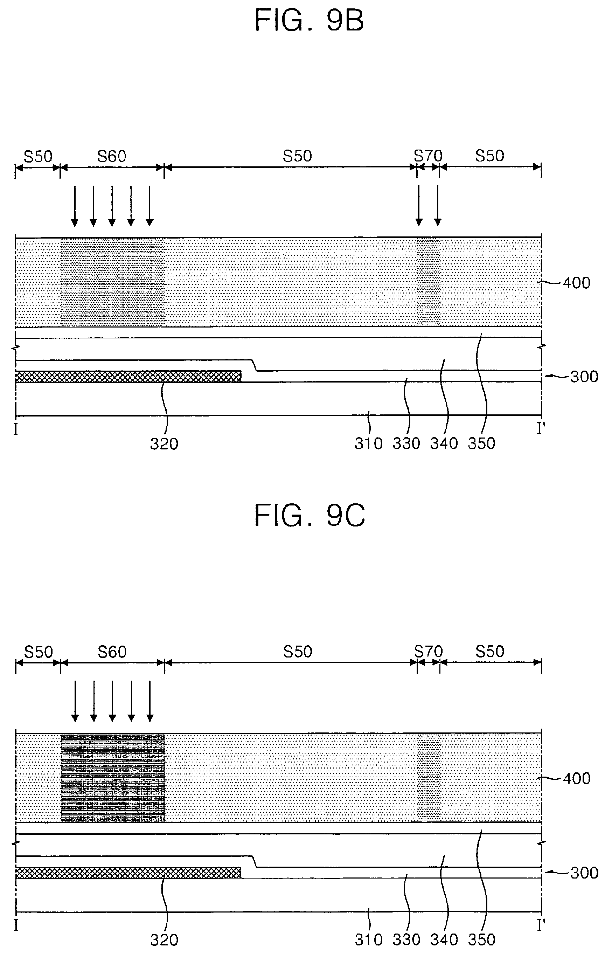

Next, as shown in FIG. 9B, the third photoresist 400 which has undergone the first light exposure process is subjected to a second light exposure process using the digital exposure unit 180. At this time, an angle of the micromirror 135 of the DMD 134 contained in the exposure head 130 of the digital exposure unit 180 is adjusted to irradiate the laser beam only to the column spacer region S60 and the protruding region S70 of the third photoresist 400.

Subsequently, as shown in FIG. 9C, the third photoresist 400 which has undergone the second light exposure process is subjected to a third light exposure process using the digital exposure unit 180. At this time, an angle of the micromirror 135 of the DMD 134 is adjusted to irradiate the laser beam only to the column spacer region S60 of the third photoresist 400.

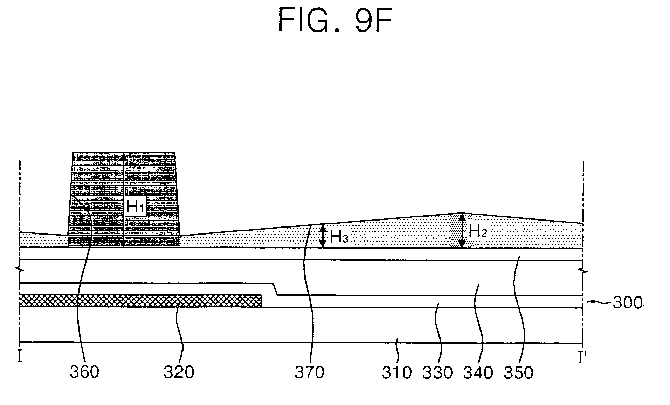

The third photoresist 400 which has undergone the three light exposure processes is subjected to a development process according to a region, so that the third photoresist has different thicknesses according to the regions. That is, as shown in FIG. 9F, a development process is performed so that the third photoresist 400 of the column spacer region S60 has a height H1, thereby forming the column spacer 360. The third photoresist 400 of the protruding region S70 is partially removed to have a height H2 which is lower than the height H1. An inclined region S50 is partially removed to have the height H3 which is lower than the height H2, where the inclined region S50 is formed between the protruding region S70 and the column spacer region S60. The third photoresist 400 of the protruding region S70 and the inclined region S50 serve as the alignment layer 370 for determining an alignment direction of the liquid crystal molecules 500. That is, if the liquid crystal molecules 500 are vertically aligned, the liquid crystal molecules 500 are vertically aligned along an inclined surface defined by a vertex of the protruding region S70 and the inclined region S50. Therefore, it is possible to adjust an alignment angle of the vertically aligned liquid crystal molecules 500. Here, the inclined angle of the alignment layer 370 can be variously adjusted such that the inclined region S50 is divided into a plurality of regions and a different intensity of the laser beam is irradiated to each region or a different number of light exposure processes is performed for each region. Also, the inclined angle of the alignment layer 370 can be variously adjusted by adjusting an angle of the micromirror 135 to diversify the amount of the laser beam irradiated to the inclined region S50.

In alternative exemplary embodiments, the third photoresist 400 may be made of a photoresist with positive photosensitivity.

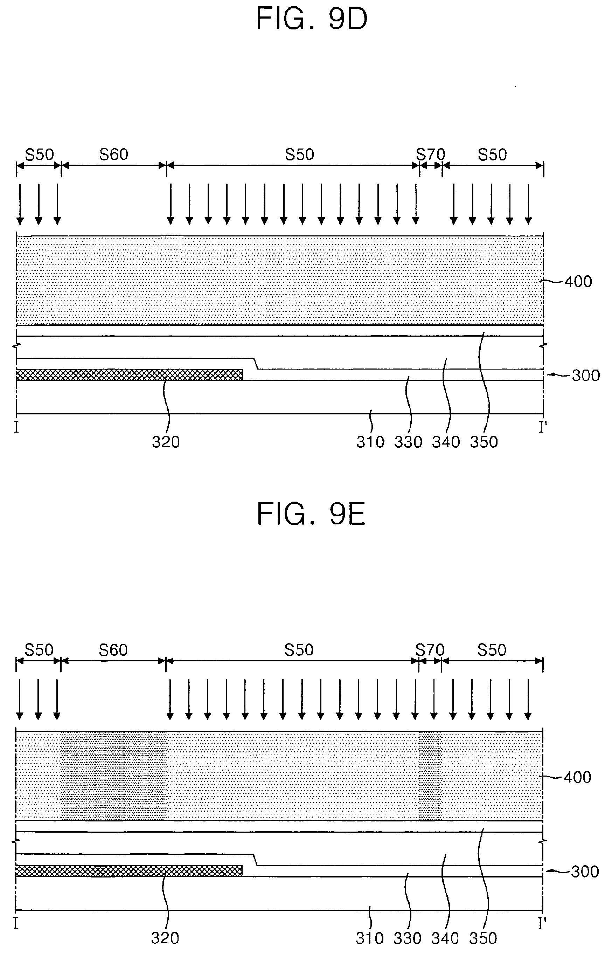

FiGs. 9D and 9E are cross-sectional views sequentially illustrating an exemplary light exposure process using a photoresist with positive photosensitivity.

Referring to FIG. 9D, the upper substrate 310 having the third photoresist 400 formed thereon is subjected to a first light exposure process using the digital exposure unit 180. At this time, the laser beam is irradiated to only to the inclined region S50 of the third photoresist 400.

Thereafter, as shown in FIG. 9E, the third photoresist 400 which has undergone the first light exposure process is subjected to a second light exposure process using the digital exposure unit 180. At this time, an angle of the micromirror 135 of the DMD 134 contained in the exposure head of the digital exposure unit 180 is adjusted to irradiate the laser beam only to the protruding region S70 and the inclined region S50 of the third photoresist 400. That is, the laser beam is irradiated to the remaining regions of the third photoresist 400 except for the column spacer region S60.

Subsequently, the third photoresist 400 which has undergone the second light exposure process is developed to thereby form the column spacer 360 and the alignment layer 370 as shown in FIG. 9F.

During the first light exposure process, the inclined angle of the alignment layer 370 can be adjusted such that the inclined region S50 is divided into a plurality of regions, and a different intensity of the laser beam is irradiated to each region or a different number of the light exposure processes is performed for each region. Also, during the second light exposure process, the inclined angle of the alignment layer 370 can be adjusted such that the inclined region S50 is divided into a plurality of regions, and a different intensity of the laser beam is irradiated to each region or the different number of the light exposure process is performed for each region.

While the column spacer 360 and the alignment layer 370 are described as formed on the color filter array substrate 300, the column spacer 360 and the alignment layer 370 may alternatively be formed on the TFT array substrate 101 by the above described methods.

The methods for manufacturing the display panel according to the exemplary embodiments of the present invention can also be applied to a method for manufacturing a lower substrate of an organic light emitting display device.

As described above, the exemplary methods for manufacturing the display device according to the present invention can reduce manufacturing costs because a high cost mask is not used.

Also, the photoresist pattern which has different thickness according to a region can be formed through the light exposure process performed several times, and so the photoresist pattern having the step portion can be formed.

Although the present invention has been described with reference to certain exemplary embodiments thereof, it will be understood by those skilled in the art that a variety of modifications and variations may be made to the present invention without departing from the spirit or scope of the present invention defined in the appended claims, and their equivalents.

## Claims

1. A method for forming a photoresist pattern, the method comprising:
forming a photoresist; and
forming a photoresist pattern having a step portion by performing a light exposure process a different number of times according to a region.

2. The method of claim 1, wherein the photoresist pattern comprises a first region and a second region lower than the first region, wherein a number of light exposure times for the first region is more than a number of light exposure times for the second region.

3. The method of claim 2, further comprising,
subjecting first and second regions of the photoresist, corresponding to the first and second regions of the photoresist pattern, to a first light exposure; and
subjecting the first region of the photoresist to a second light exposure.

4. The method of claim 3, wherein during the first light exposure, light of different intensity is irradiated to the first and second regions of the photoresist, respectively.

5. The method of claim 4, wherein during the first light exposure, light of stronger intensity is irradiated to the first region of the photoresist than to the second region of the photoresist.

6. The method of claim 4, further comprising,
during the first light exposure, irradiating light of same intensity to the first and second regions of the photoresist; and
during the second light exposure, irradiating light of different intensity compared to the first light exposure.

7. The method of claim 1, wherein the photoresist pattern comprises a first region and a second region lower than the first region, wherein a number of light exposure times for the first region is less than a number of light exposure times for the second region.

8. A method for manufacturing a display panel, the method comprising:
forming a gate pattern having a gate line and a gate electrode on a substrate through a first conductive layer;
sequentially forming a gate insulating layer, an amorphous silicon layer, a doped amorphous silicon layer, a second conductive layer, and a photoresist over the substrate, wherein the photoresist includes a channel region, through which a channel of a thin film transistor is to be formed, and a data pattern region, through which a data pattern having source and drain electrodes of the thin film transistor and a data line is to be formed;
subjecting the photoresist to a light exposure to form a photoresist pattern having a step portion, wherein the channel region and the data pattern region receive a different number of light exposure times;
performing an etching process using the photoresist pattern to form the thin film transistor and the data line;
forming a passivation film over the substrate, the passivation film having a pixel contact hole which exposes a portion of a drain electrode; and
forming a pixel electrode on the passivation film, the pixel electrode electrically connected to the drain electrode via the pixel contact hole.

9. The method of claim 8, wherein the photoresist has negative photosensitivity.

10. The method of claim 9, wherein the photoresist pattern having a step portion includes a data pattern region through which the source and drain electrodes and the data line are to be formed and a channel region through which the channel of the thin film transistor is to be formed, and the data pattern region of the photoresist pattern is higher than the channel region of the photoresist pattern.

11. The method of claim 1.0, wherein the number of light exposure times for the channel region of the photoresist is less than the number of light exposure times for the data pattern region of the photoresist.

12. The method of claim 11, further comprising,
subjecting the photoresist of the channel region and the data pattern region to a first light exposure; and
subjecting the photoresist of the data pattern region to a second light exposure.

13. The method of claim 12, wherein during the first light exposure, light of different intensity is irradiated to the channel region of the photoresist and the data pattern region of the photoresist, respectively.

14. The method of claim 13, wherein during the first light exposure, light of stronger intensity is irradiated to the data pattern region of the photoresist than to the channel region of the photoresist.

15. The method of claim 12, further comprising,
during the first light exposure, irradiating light of same intensity to the channel region of the photoresist and the data pattern region of the photoresist; and
during the second light exposure, irradiating light of different intensity compared to the first light exposure.

16. The method of claim 15, further comprising, after the second light exposure, subjecting the data pattern region to at least one more light exposure.

17. The method of claim 8, wherein the photoresist has positive photosensitivity.

18. The method of claim 17, wherein the photoresist pattern having a step portion includes a data pattern region through which the source and drain electrodes and the data line are to be formed and a channel region through which the channel of the thin film transistor is to be formed, and the data pattern region of the photoresist pattern is higher than the channel region of the photoresist pattern.

19. A method for manufacturing a display device, the method comprising:
preparing a thin film transistor array substrate;
preparing a color filter array substrate, opposite to the thin film transistor array substrate;
forming a photoresist on any of the thin film transistor array substrate and the color filter array substrate; and
subjecting the photoresist to a light exposure at least twice to form a column spacer and an alignment layer which has a protruding portion and an inclined portion for alignment of liquid crystal molecules.

20. The method of claim 19, wherein the photoresist has negative photosensitivity.

21. The method of claim 20, further comprising,
subjecting a surface of the photoresist to a first light exposure;
subjecting a portion of the photoresist through which the column spacer is to be formed and the protruding portion to a second light exposure; and
subjecting the portion of the photoresist through which the column spacer is to be formed to a third light exposure.

22. The method of claim 21, wherein light of stronger intensity is supplied for the third light exposure compared to the second light exposure.

23. The method of claim 22, further comprising, after the third light exposure, subjecting the portion of the photoresist through which the column spacer is to be formed to a light exposure.

24. The method of claim 19, wherein the photoresist has positive photosensitivity.
